(19) Europäisches Patentamt
European Patent Office
Office européen des brevets

(11) EP 3 599 261 A1

(12) EUROPEAN PATENT APPLICATION

(43) Date of publication:
**29.01.2020 Bulletin 2020/05**

(51) Int Cl.:
***C09J 7/00*** *(2018.01)* ***H01L 33/64*** *(2010.01)*

(21) Application number: **19188301.6**

(22) Date of filing: **25.07.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.07.2018 JP 2018141176**

(71) Applicant: **Nitto Denko Corporation**
**Ibaraki-shi, Osaka 567-8680 (JP)**

(72) Inventors:
- **SUZUKI, Tatsuya**
  **Ibaraki-shi, Osaka 567-8680 (JP)**
- **NAKANO, Takeshi**
  **Ibaraki-shi, Osaka 567-8680 (JP)**
- **IEDA, Hiroki**
  **Ibaraki-shi, Osaka 567-8680 (JP)**

(74) Representative: **Müller-Boré & Partner Patentanwälte PartG mbB**
**Friedenheimer Brücke 21**
**80639 München (DE)**

# (54) THERMALLY CONDUCTIVE SHEET

(57) Provided is a thermally conductive sheet with greater optical transmission. The thermally conductive sheet provided by this invention has a resin layer that comprises a resin and a thermally conductive filler. The resin has a refractive index np and the thermally conductive filler has a refractive index nf, satisfying the next relational expression $-0.04 \leq (np - nf) \leq 0.04$. According to a preferable embodiment, the thermally conductive filler content is 50 parts by weight or more and 250 parts by weight or less to 100 parts by weight of the resin.

[Fig. 1]

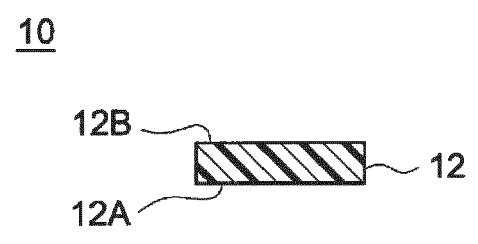


EP 3 599 261 A1

## Description

The present invention claims priority to Japanese Patent Application No. 2018-141176 filed on July 27, 2018; and the entire content thereof is incorporated herein by reference.

The present invention relates to a thermally conductive sheet.

Recently, with the technological advancement in electronic devices (e.g. semiconductor devices) and the like, their heat generation tends to increase. This makes it increasingly important to design electronic devices with heat dissipation capabilities. Under such a circumstance, a thermally conductive sheet is used in an electronic device to transfer heat generated by a heat-generating body to a heat-dissipating body, placed between them. The heat-generating body can be a light-emitting diode (LED) or an organic light-emitting diode (OLED), etc. The heat-dissipating body can be a case or a heat spreader. In a typical embodiment of the thermally conductive sheet, a thermally conductive layer is included, comprising a thermally conductive filler dispersed in a resin. A technical literature related to thermally conductive sheets includes Japanese Patent Application Publication No. 2013-176980.

With respect to conventional thermally conductive sheets, transparency to visible light has not been particularly discussed. In the device construction, a thermally conductive sheet with higher transparency (optical transmission), if available, may lead to effects such as superior accuracy and increased productivity. For instance, when placing the thermally conductive sheet between a heat-generating body and a heat-dissipating body in the process of constructing the device, it is easy to locate where the thermally conductive sheet is to be placed as the sheet is see-through in the thickness direction.

The present invention has been made in view of such an aspect with an objective to provide a thermally conductive sheet with higher optical transmission.

[Solution to Problem]

The present invention provides a thermally conductive sheet that has a resin layer comprising a resin and a thermally conductive filler. Here, the resin and the thermally conductive filler differ in refractive index by 0.04 or less. In other words, the resin has a refractive index np and the thermally conductive filler has a refractive index nf, satisfying the next relational expression $-0.04 \leq (np - nf) \leq 0.04$. According to such an embodiment, the thermally conductive sheet may have a higher transparency (optical transmittance).

In the thermally conductive sheet according to a preferable embodiment disclosed herein, the thermally conductive filler content is 50 parts by weight or more and 250 parts by weight or less to 100 parts by weight of the resin. Both good transparency and high thermal conduction can be favorably obtained with the thermally conductive sheet having a resin layer that includes at least 50 parts up to 250 parts (by weight) thermally conductive filler to 100 parts by weight of resin, wherein the resin has a refractive index np and the thermally conductive filler has a refractive index nf, satisfying the next relational expression $-0.04 \leq (np - nf) \leq 0.04$.

In the thermally conductive sheet according to another preferable embodiment disclosed herein, the resin comprises an acrylic polymer as the base polymer. According to an embodiment having a resin layer that includes such a resin, a thermally conductive sheet with good optical transmission is likely to be obtained.

In the thermally conductive sheet according to another preferable embodiment disclosed herein, the acrylic polymer is a polymer of monomers (starting monomers) comprising a monomer A whose homopolymer is a highly refractive polymer having a refractive index of 1.50 or higher. According to such an embodiment, in the resulting resin layer, the difference in refractive index is likely to be small between the resin and the thermally conductive filler, possibly leading to an increase in optical transmission of the thermally conductive sheet.

In the thermally conductive sheet according to another preferable embodiment disclosed herein, the monomer A is at least one species selected from the group consisting of a fluorene-based (meth)acrylate, phenylphenol (meth)acrylate and benzyl (meth)acrylate. When such a monomer A is used, in the resulting resin layer, the difference in refractive index is likely to be small between the resin and the thermally conductive filler, possibly leading to an increase in optical transmission of the thermally conductive sheet.

In the thermally conductive sheet according to another preferable embodiment disclosed herein, the monomer A accounts for 50 % by weight or more of the total amount of the monomers. According to such an embodiment, in the resulting resin layer, the difference in refractive index is likely to be small between the resin and the thermally conductive filler, possibly leading to a further increase in optical transmission of the thermally conductive sheet.

In the thermally conductive sheet according to another preferable embodiment disclosed herein, the thermally conductive filler comprises a hydrated metal compound (e.g. aluminum hydroxide). According to such an embodiment, it is possible to obtain a thermally conductive sheet with high thermal conduction and increased optical transmission.

In the thermally conductive sheet according to another preferable embodiment disclosed herein, the resin's refractive index np is 1.49 or higher and 1.65 or lower. With the use of a resin having such a refractive index np, in the resulting resin layer, the difference in refractive index is likely to be small between the resin and the thermally conductive

filler (e.g. a hydrated metal compound such as aluminum hydroxide), possibly leading to a further increase in optical transmission of the thermally conductive sheet.

In a preferable embodiment of the thermally conductive sheet disclosed herein, the resin layer is a pressure-sensitive adhesive layer (a PSA layer). In an embodiment of use where the resin layer is directly applied to an adherend, the thermally conductive sheet in such an embodiment can be placed in tight contact with the adherend; and therefore, the thermal conduction from the adherend may increase. According to such an embodiment, the thermally conductive sheet can also be used for purposes such as fastening and bonding of the adherend in addition to the purposes such as thermal dissipation and conduction of the adherend.

Fig. 1 shows a schematic cross-sectional diagram illustrating the thermally conductive sheet according to an embodiment.

Fig. 2 shows a schematic cross-sectional diagram illustrating the thermally conductive sheet according to another embodiment.

Fig. 3 shows a schematic cross-sectional diagram illustrating the thermally conductive sheet according to yet another embodiment.

Fig. 4 shows a schematic cross-sectional diagram illustrating the thermally conductive sheet according to yet another embodiment.

Fig. 5(a) shows a diagram outlining the front view of the thermal analysis instrument used for determining thermal resistance in Examples and Fig. 5(b) shows a diagram outlining the lateral view of the instrument shown in Fig. 5(a).

Preferable embodiments of the present invention are described below. Matters necessary to practice this invention other than those specifically referred to in this description can be understood by a person skilled in the art based on the disclosure about implementing the invention in this description and common technical knowledge at the time the application was filed. The present invention can be practiced based on the contents disclosed in this description and common technical knowledge in the subject field.

In the following drawings, components or units having the same functions may be described with the same symbols allocated and the redundant description may be omitted or simplified. The embodiments illustrated in the drawings are schematic in order to clearly describe the present invention and the drawings do not accurately represent the size or scale of products actually provided.

<Structural examples of thermally conductive sheet>

The thermally conductive sheet disclosed herein includes a resin layer. The resin layer can be a PSA layer (a pressure-sensitive adhesive layer) or a non-adhesive layer. When the resin layer is a PSA layer, the thermally conductive sheet whose one or each face is formed with the surface (adhesive face) of the resin layer can be thought as a thermally conductive PSA sheet.

As used herein, the "PSA layer" refers to a layer having a peel strength of 0.1 N/20mm or greater when determined using a SUS304 stainless steel plate as the adherend based on JIS Z0237(2004) as follows: In a measurement environment at 23 °C, a PSA test piece is press-bonded to the adherend with a 2 kg roller moved back and forth once and at 30 minutes after press-bonded, the test piece is peeled at a tensile speed of 300 mm/min in the 180° direction to determine the peel strength. As used herein, the "non-adhesive layer" refers to a layer that does not correspond to the PSA layer described above, typically referring to a layer having a peel strength less than 0.1 N/20mm. A typical example included in the concept of non-adhesive layer as referred to herein is a layer that does not adhere (a layer essentially non-adhesive) to a SUS304 stainless steel plate when pressed onto the stainless steel plate with a 2 kg roller moved back and forth once in a measurement environment at 23 °C.

The thermally conductive sheet disclosed herein may be formed of the resin layer. In other words, the thermally conductive sheet disclosed herein can be a substrate-free resin sheet having a first face formed with one surface of the resin layer and a second face formed with the other surface of the resin layer.

Fig. 1 schematically illustrates the structure of the thermally conductive sheet according to an embodiment. This thermally conductive sheet is configured as a substrate-free thermally conductive sheet 10 formed of a resin layer 12 which is a non-adhesive layer. Thermally conductive sheet 10 has a first face 12A which is a non-adhesive face formed with one surface of resin layer 12 and a second face 12B which is a non-adhesive face formed with the other surface of resin layer 12. When thermally conductive sheet 10 is used, the first and second faces 12A and 12B are arranged to make tight contact with different areas of other member(s), respectively. The areas to which the first and second faces 12A and 12B are placed with tight contact can be corresponding areas in different members or different areas in a single member.

Fig. 2 schematically illustrates the structure of the thermally conductive sheet according to another embodiment. This thermally conductive sheet is configured as a substrate-free thermally conductive PSA sheet (adhesively double-faced PSA sheet) 20 formed of a pressure-sensitive adhesive resin layer (PSA layer) 22. Thermally conductive PSA sheet 20 has a first adhesive face 22A formed with one surface of resin layer 22 and a second adhesive face 22B formed with the other surface of resin layer 22. When thermally conductive PSA sheet 20 is used, adhesive faces 22A and 22B are applied to different areas of adherend(s). The areas to which adhesive faces 22A and 22B are applied can be corresponding areas in different members or different areas in a single member. As shown in Fig. 2, thermally conductive PSA sheet 20 prior to use (i.e. before applied to an adherend) can be a component of a release-lined thermally conductive PSA sheet 200 in which the first and second adhesive faces 22A and 22B are protected with release liners 24 and 26 having release surfaces at least on sides facing resin layer 22. As for release liner 24 or 26, for instance, it is preferable to use a liner formed by providing a release agent layer (release layer) to one face of a substrate sheet so that the one face has a release surface. Alternatively, release liner 26 can be eliminated; instead, release liner 24 having a release surface on each face can be layered with thermally conductive PSA sheet 20 and wound together to form a release-lined thermally conductive PSA sheet (in a roll) in which the second adhesive face 22B is in contact with and protected with the back side of release liner 24.

Alternatively, the thermally conductive sheet disclosed herein can be a substrate-supported thermally conductive sheet in which the resin layer is laminated on one or each face of a support substrate. Hereinafter, the support substrate may be simply referred to as the "substrate." In the thermally conductive sheet in such an embodiment, the resin layer can be a PSA layer or a non-adhesive layer. From the standpoint of enhancing the tightness to the substrate, the resin layer is preferably a PSA layer.

Fig. 3 schematically illustrates the structure of the thermally conductive sheet according to an embodiment. This thermally conductive sheet is configured as a substrate-supported thermally conductive PSA sheet (adhesively double-faced PSA sheet) 30 having a support substrate sheet 32 (e.g. resin film) that has first and second faces 32A and 32B, a first pressure-sensitive adhesive resin layer 34 fixed to the first face 32A side, and a second pressure-sensitive adhesive resin layer 36 fixed to the second face 32B side. As shown in Fig. 3, thermally conductive PSA sheet 30 prior to use may be a component of a release-lined thermally conductive PSA sheet 300 in which the surface (first adhesive face) 34A of first resin layer 34 and the surface (second adhesive face) 36A of second resin layer 36 are protected with release liners 38 and 39. Alternatively, release liner 39 can be eliminated; instead, release liner 38 having a release surface on each face can be layered with thermally conductive PSA sheet 30 and wound together to form a release-lined thermally conductive PSA sheet (in a roll) in which the second adhesive face 36A is in contact with and protected with the back side of release liner 38.

In thermally conductive sheet 30 in such an embodiment, the material forming support substrate 32 is not particularly limited. From the standpoint of obtaining thermally conductive sheet 30 with good optical transmission, a transparent resin film can be preferably used as support substrate 32. Non-limiting examples of the resin film include polyolefin films whose primary components are polyolefins such as polypropylene and ethylene-polypropylene copolymers; polyester films whose primary components are polyesters such as polyethylene terephthalate (PET) and polybutylene terephthalate; and polyvinyl chloride films whose primary components are polyvinyl chlorides. In a favorable example, from the standpoint of the transparency, PET film can be preferably used.

Alternatively, the thermally conductive sheet disclosed herein can be a thermally conductive PSA sheet in which a PSA layer is laminated on one or each face of a resin layer. In the thermally conductive sheet (thermally conductive PSA sheet) in such an embodiment, the resin layer can be a PSA layer or a non-adhesive layer. According to such an embodiment, even if the thermally conductive sheet includes a non-adhesive resin layer, an adhesive face can be formed on one or each face of the thermally conductive sheet with the PSA layer laminated on the one or each face of the resin layer.

Fig. 4 schematically illustrates the structure of the thermally conductive sheet according to an embodiment. This thermally conductive sheet is configured as a thermally conductive PSA sheet (adhesively double-faced sheet) 40 having a resin layer 42 that has first and second faces 42A and 42B, a first PSA layer 44 fixed to the first face 42A side, and a second PSA layer 46 fixed to the second face 42B side. As shown in Fig. 4, thermally conductive PSA sheet 40 prior to use may be a component of a release-lined thermally conductive PSA sheet 400 in which the surface (first adhesive face) 44A of first PSA layer 44 and the surface (second adhesive face) 46A of second PSA layer 46 are protected with release liners 48 and 49. Alternatively, release liner 49 can be eliminated; instead, release liner 48 having a release surface on each face can be layered with thermally conductive PSA sheet 40 and wound together to form a release-lined thermally conductive PSA sheet (in a roll) in which the second adhesive face 46A is in contact with and protected with the back side of release liner 48.

The PSA in the first PSA layer 44 and the second PSA layer 46 is not particularly limited. The PSA may comprise, as the base polymer (i.e. a component accounting for 50 % by weight or more of polymers), one, two or more species among various polymers, for instance, acrylic polymers, rubber-based polymers, polyester-based polymers, urethane-based polymers, polyether-based polymers, silicone-based polymers, polyamide-based polymers, and fluoropolymers.

The concept of PSA sheet herein may encompass so-called PSA tapes, PSA films, PSA labels, etc. The PSA sheet can be in a roll or in a flat sheet or may be cut or punched out into a suitable shape according to the purpose and

application. When the thermally conductive sheet is a thermally conductive pressure-sensitive adhesive (PSA) sheet having a PSA layer on one or each face of the resin layer, the PSA layer is typically formed in a continuous form, but is not limited to this. For instance, it may be formed in a regular or random pattern of dots, stripes, etc.

<Properties of thermally conductive sheet>

The thermal conductivity (by a stationary heat flow method; the same applies, hereinafter) of the thermally conductive sheet disclosed herein is not particularly limited. In typical, it is 0.15 W/m·K or greater. When placed between components for which heat dissipation or heat conduction is desired, with increasing thermal conductivity, it is more likely to be favorably used for purposes such as heat dissipation and heat conduction of the components. The thermal conductivity is preferably 0.2 W/m·K or greater, more preferably 0.25 W/m·K or greater, or yet more preferably 0.28 W/m·K or greater; for instance, it can be 0.3 W/m·K or greater, 0.35 W/m·K or greater, 0.4 W/m·K or greater, or even 0.48 W/m·K or greater. The maximum thermal conductivity of the thermally conductive sheet is not particularly limited. In some embodiments, in view of the balance with other properties such as transparency, the thermal conductivity of the thermally conductive sheet can be, for instance, 2.0 W/m·K or less, 1.5 W/m·K or less, 1.0 W/m·K or less, 0.8 W/m·K or less, 0.5 W/m·K or less, or even less than 0.5 W/m·K. In some embodiments, the thermal conductivity of the thermally conductive sheet can be 0.45 W/m·K or less, 0.40 W/m·K or less, 0.35 W/m·K or less, or even 0.32 W/m·K or less.

As used herein, the thermal conductivity of a thermally conductive sheet refers to a value determined by a stationary heat flow method. More specifically, the thermal conductivity of a thermally conductive sheet can be determined by the method described later in Examples.

A thermally conductive sheet having favorable thermal conduction as described above can efficiently conduct heat when placed in tight contact between components (typically between a heat-generating body and a heat-dissipating body) in an electronic device and the like. A thermally conductive sheet that can be favorably used in such an embodiment includes a thermally conductive material that mainly contributes to thermal conduction, typically dispersed, in a medium such as a resin with prescribed flexibility. This is because, when put in conformity with contours of components to make tight contact, it is capable of reducing heat resistance at interfaces between the components and the thermally conductive sheet. However, thermally conductive sheets in such embodiments have tended to suffer decreases in optical transmission (transparency) due to, for instance, optical refraction, dispersion, reflection, diffraction and so on at interfaces of media and of thermally conductive materials in the media, etc.

According to the art disclosed herein, with the difference in refractive index at or below 0.04 between the resin and the thermally conductive filler in the resin layer, a thermally conductive sheet with a favorably increased transmittance can be obtained.

The transmittance of the thermally conductive sheet disclosed herein is not particularly limited. For instance, the transmittance of the thermally conductive sheet is preferably 60 % or higher, more preferably 70 % or higher, or yet more preferably 80 % or higher (e.g. 85 % or higher). The maximum transmittance of the thermally conductive sheet is not particularly limited. From the standpoint of achieving a balance with other properties such as thermal conduction and adhesive properties, it is usually suitably 99 % or lower, possibly 95 % or lower, or even 90 % or lower.

Herein, the transmittance of a thermally conductive sheet can be determined at a temperature of 23 °C at a measurement wavelength of 400 nm, using a commercial transmittance meter (e.g. a high-speed integrating sphere spectrophotometric transmittance meter, model DOT-3, available from Murakami Color Research Laboratory). More specifically, the transmittance of the thermally conductive sheet can be determined by the method described later in Examples.

<Resin layer>

The thermally conductive sheet disclosed herein includes a resin layer. Here, the refractive index np of the resin in the resin layer is not particularly limited. The refractive index nf of the thermally conductive filler contained along with the resin in the resin layer tends to be relatively high as compared to refractive indices of resins generally used in the field of PSA sheets. Thus, when a resin with a relatively high refractive index is used, the difference in refractive index from the thermally conductive filler is likely to favorably decrease.

The refractive index np of the resin in the resin layer depends on the type of thermally conductive filler used with the resin; however, in some embodiments, it is preferably 1.49 or higher, more preferably 1.51 or higher, or yet more preferably 1.53 or higher. In some embodiments, the resin's refractive index np can be 1.55 or higher, 1.56 or higher, or even 1.57 or higher. The resin's maximum refractive index np depends on the type of thermally conductive filler used; however, in some embodiments, it is preferably 1.65 or lower, more preferably 1.63 or lower, or yet more preferably 1.61 or lower. From the standpoint of achieving a balance with other properties, in some embodiments, the resin's refractive index np can be 1.59 or lower, 1.57 or lower, 1.55 or lower, or even 1.54 or lower.

Herein, the refractive index np of a resin can be determined, using a commercial Abbe refractometer (e.g.

model DR-M2 available from ATAGO Co., Ltd.). More specifically, the resin's refractive index np can be determined by the method described later in Examples. The same is true with the thermally conductive filler's refractive index nf described later.

In the art disclosed herein, the resin in the resin layer is not particularly limited. As its base polymer (i.e. a component accounting for 50 % by weight or more of the polymers), the resin may comprise, one, two or more species among various polymers, for instance, acrylic polymer, rubber-based polymer, polyester-based polymer, urethane-based polymer, polyether-based polymer, silicone-based polymer, polyamide-based polymer and fluoropolymers. The resin layer in the art disclosed herein may be formed from a resin composition comprising such a base polymer. The form of the resin composition is not particularly limited. The resin composition can be in various forms, for instance, water-dispersed, hot melt, and active energy ray-curable (e.g. photo curable) forms.

As used herein, the term "active energy ray" refers to an energy ray having energy capable of causing a chemical reaction such as polymerization, crosslinking, initiator decomposition, etc. Examples of the active energy ray herein include lights such as ultraviolet (UV) rays, visible light, infrared light, radioactive rays such as $\alpha$ rays, $\beta$ rays, $\gamma$ rays, electron beam, neutron radiation, and X rays.

While no particular limitations are imposed, the weight average molecular weight (Mw) of the base polymer can be, for instance, about $5 \times 10^4$ or higher. With a base polymer having such a Mw, a resin that shows good cohesion is likely to be obtained. In some embodiments, the base polymer's Mw can be, for instance, $10 \times 10^4$ or higher, $20 \times 10^4$ or higher, or even $30 \times 10^4$ or higher. The base polymer's Mw is usually suitably about $500 \times 10^4$ or lower. The base polymer with such a Mw is suited for forming a resin layer that conforms well to contours.

The Mw of the base polymer can be determined as a value based on standard polystyrene by gel permeation chromatography (GPC). The GPC analysis can be carried out, using, for instance, a GPC system HLC-8220GPC available from Tosoh Corporation under the conditions shown below.

[GPC Analysis]

Sample concentration: 0.2 % by weight (tetrahydrofuran (THF) solution)
Sample injection: 10 $\mu$L
Eluent: THF, flow rate: 0.6 mL/minute
Measurement temperature: 40 °C
Columns:

Sample columns; 1 TSK guardcolumn SuperHZ-H + 2 TSKgel SuperHZM-H columns
Reference column; 1 TSKgel SuperH-RC column

Detector: differential refractometer (RI)

(Highly refractive monomer A)

The base polymer preferably comprises a monomeric unit formed from a monomer (or a "highly refractive monomer A" hereinafter) whose homopolymer is a highly refractive polymer having a refractive index of 1.50 or higher. In other words, the base polymer is preferably a polymer of monomers (starting monomers) that include a highly refractive monomer A whose homopolymer is a highly refractive polymer. With the highly refractive monomer A included in the starting monomers of the base polymer, the refractive index of the base polymer can be readily adjusted to a favorable range. Adjustment of the base polymer's refractive index contributes to adjustment of the refractive index np of the resin comprising the base polymer as the primary component. Thus, the use of such a highly refractive monomer A can favorably bring about a resin layer that comprises a resin that differs only slightly if any in refractive index from the thermally conductive filler.

In the art disclosed herein, with respect to the highly refractive monomer A that can be favorably used, its homopolymer (highly refractive polymer) has a refractive index of preferably 1.51 or higher, more preferably 1.52 or higher, yet more preferably 1.53 or higher (e.g. 1.54 or higher), possibly 1.55 or higher, 1.56 or higher, or even 1.57 or higher. When using a highly refractive monomer A whose homopolymer (highly refractive polymer) has a high refractive index, the resin's refractive index np can be easily adjusted over a wide range. The maximum refractive index of homopolymer (highly refractive polymer) of the highly refractive monomer A is not particularly limited. From the standpoint of achieving a balance with other properties, the refractive index of the highly refractive monomer A's homopolymer (highly refractive polymer) is suitably about 1.7 or lower, preferably 1.65 or lower, more preferably 1.63 or lower, yet more preferably 1.61 or lower, possibly 1.60 or lower, lower than 1.60, 1.59 or lower, or even 1.58 or lower.

In the art disclosed herein, an example of the highly refractive monomer A that can be favorably used is a monomer that includes at least one species selected among, for instance, a sulfur atom, a halogen atom (preferably not a fluorine atom, e.g. a bromine or an iodine), a phosphorous atom and an aromatic ring. With the use of such a highly refractive monomer A, a base polymer with a relatively high refractive index is likely to be obtained. In particular, a monomer having an aromatic ring is preferable.

Examples of the aromatic ring-containing monomer include styrene; styrene derivatives such as $\alpha$-methylstyrene; aromatic ring-containing (meth)acrylates such as benzyl (meth)acrylate, naphthyl (meth)acrylate, phenoxyethyl (meth)acrylates, phenoxybutyl (meth)acrylate, phenylphenol (meth)acrylate which may be ethoxylated, and fluorene-based (meth)acrylates; and toluene derivatives such as vinyltoluene and $\alpha$-vinyltoluene. An example of a monomer that has an aromatic ring and contains a sulfur atom is phenyl vinyl sulfide. Among these, solely one species or a combination of two or more species can be used.

From the standpoint of favorable adjustment of the base polymer's refractive index, the ratio of highly refractive monomer A in the total amount of starting monomers of the base polymer is preferably 50 % by weight or higher. The highly refractive monomer A content in the starting monomers is more preferably 55 % by weight or higher; it can be 60 % by weight or higher as well. In some embodiments, the ratio of highly refractive monomer A in the total amount of starting monomers is preferably 70 % by weight or higher, possibly 80 % by weight or higher, 90 % by weight or higher, or even 99 % by weight or higher. For the ease of achieving a balance with other properties such as adhesive properties, in some embodiments, the ratio of highly refractive monomer A in the total amount of staring monomers can be 80 % by weight or lower, 75 % by weight or lower, 70 % by weight or lower, or even 65 % by weight or lower.

When the starting monomers of the base polymer include two or more species of highly refractive monomer A, the highly refractive monomer A content in the starting monomers refers to the combined amount of the two or more species of highly refractive monomer A.

In the art disclosed herein, the base polymer is preferably an acrylic polymer.

As used herein, the term "acrylic polymer" refers to a polymer having a monomeric unit derived from a (meth)acrylic monomer in the polymer structure and typically refers to a polymer containing over 50% by weight monomeric units derived from a (meth)acrylic monomer.

The term "(meth)acrylic monomer" refers to a monomer having at least one (meth)acryloyl group in one molecule. In this context, it is intended that the term "(meth)acryloyl group" collectively refers to an acryloyl group and a methacryloyl group. Therefore, the concept of "(meth)acrylic monomer" as used herein may encompass both an acrylic monomer having an acryloyl group and a methacrylic monomer having a methacryloyl group. Similarly, it is intended that the term "(meth)acrylic acid" as used herein collectively refers to acrylic acid and methacrylic acid and the term "(meth)acrylate" collectively refers to an acrylate and a methacrylate.

The acrylic polymer may include a monomeric unit formed from an acrylic monomer that is a highly refractive monomer A (or a highly refractive acrylic monomer Aa). Examples of the highly refractive acrylic monomer Aa include an aromatic ring-containing (meth)acrylate, a sulfur-containing (meth)acrylate, and a halogenated (meth)acrylate. Among these, solely one species or a combination of two or more species can be used.

In particular, an aromatic ring-containing (meth)acrylate can be preferably used.

Non-limiting examples of the (meth)acrylate having an aromatic ring include benzyl (meth)acrylate, naphthyl (meth)acrylate, phenoxyethyl (meth)acrylate, phenoxybutyl (meth)acrylate, phenylphenol (meth)acrylate which may be ethoxylated, and fluorene-based (meth)acrylates. Among them, fluorene-based (meth)acrylates, phenylphenol (meth)acrylate and benzyl (meth)acrylate are preferable; fluorene-based acrylates, phenylphenol acrylate which may be ethoxylated (e.g. ethoxylated o-phenylphenol acrylate) and benzyl acrylate are more preferable.

Here, the fluorene-based (meth)acrylate is a compound (monomer) that has a fluorene backbone and a (meth)acryloyl group in the molecule, favorably a compound having a structure formed with a fluorene backbone to which a (meth)acryloyl group is bonded directly or via an oxyalkylene chain (monooxyalkylene chain or polyoxyalkylene chain). Among these fluorene-based (meth)acrylates, a so-called polyfunctional fluorene-based (meth)acrylate is preferable, with two or more (meth)acryloyl groups bonded (possibly via oxyalkylene chains) to the fluorene backbone. Specific examples of the fluorene-based (meth)acrylate include product names OGSOL EA-0200, EA-0500 and EA-1000 available from Osaka Gas Chemical Co., Ltd.

Favorable examples of the sulfur-containing (meth)acrylate include 1,2-bis(meth)acryloylthioethane, 1,3-bis(meth)acryloylthiopropane, 1,4-bis(meth)acryloylthiobutane, 1,2-bis(meth)acryloylmethylthiobenzene, and 1,3-bis(meth)acryloylmethylthiobenzene.

Favorable examples of the halogenated (meth)acrylate include 6-(4,6-dibromo-2-isopropylphenoxy)-1-hexyl acrylate, 6-(4,6-dibromo-2-s-butylphenoxy)-1- hexyl acrylate, 2,6-dibromo-4-nonylphenyl acrylate, and 2,6-dibromo-4-dodecylphenyl acrylate.

From the standpoint of favorable adjustment of the base polymer's refractive index, the ratio of highly refractive acrylic monomer Aa in the total amount of starting monomers of the base polymer is preferably 50 % by weight or higher. The highly refractive acrylic monomer Aa content in the starting monomers is more preferably 55 % by weight or higher

or it can be 60 % by weight or higher as well. In some embodiments, the highly refractive acrylic monomer Aa content in the starting monomers is preferably 70 % by weight or higher, possibly 80 % by weight or higher, 90 % by weight or higher, or even 99 % by weight or higher. For the ease of achieving a balance with other properties such as adhesive properties, in some embodiments, the highly refractive acrylic monomer Aa content in the starting monomers can be 80 % by weight or lower, 75 % by weight or lower, 70 % by weight or lower, or even 65 % by weight or lower.

When the starting monomers of the base polymer include two or more species of highly refractive acrylic monomer Aa, the highly refractive acrylic monomer Aa content in the starting monomers refers to the combined amount of the two or more species of highly refractive acrylic monomer Aa.

In some embodiments, the acrylic polymer may include a monomeric unit derived from an alkyl (meth)acrylate. A preferable alkyl (meth)acrylate has a linear or branched alkyl group with 1 to 20 carbons (i.e. $C_{1-20}$). For easy balancing of properties, in some embodiments, the ratio of $C_{1-20}$ alkyl (meth)acrylate in the total amount of monomers can be, for instance, 10 % by weight or higher, 20 % by weight or higher, or even 30 % by weight or higher. For the same reason, of the total amount of monomers, the ratio of $C_{1-20}$ alkyl (meth)acrylate can be, for instance, 50 % by weight or less, 45 % by weight or less, or even 40 % by weight or less.

Non-limiting specific examples of the $C_{1-20}$ alkyl (meth)acrylate include methyl (meth)acrylate, ethyl (meth)acrylate, propyl (meth)acrylate, isopropyl (meth)acrylate, n-butyl (meth)acrylate, isobutyl (meth)acrylate, s-butyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, stearyl (meth)acrylate, isostearyl (meth)acrylate, nonadecyl (meth)acrylate, and eicosyl (meth)acrylate.

Among these, it is preferable to use at least a $C_{1-18}$ alkyl (meth)acrylate and it is more preferable to use at least a $C_{1-14}$ alkyl (meth)acrylate. In some embodiments, the acrylic polymer may include, as a monomeric unit, at least one species selected among $C_{4-12}$ alkyl (meth)acrylates (preferably $C_{4-10}$ alkyl acrylates such as an $C_{6-10}$ alkyl acrylates). For example, the acrylic polymer preferably includes one or each of n-butyl acrylate (BA) and 2-ethylhexyl acrylate (2EHA), and the acrylic polymer particularly preferably includes at least 2EHA. Examples of other $C_{1-18}$ alkyl (meth)acrylates that are preferably used include methyl acrylate, methyl methacrylate (MMA), n-butyl methacrylate (BMA), 2-ethylhexyl methacrylate (2EHMA), and isostearyl acrylate (ISTA).

The monomers forming the acrylic polymer may include, as necessary, another monomer (or copolymerizable monomer, hereinafter) that is neither a highly-refractive monomer Aa nor an alkyl (meth)acrylate and is capable of copolymerizing with the highly-refractive monomer Aa or the alkyl (meth)acrylate. As the copolymerizable monomer, a monomer having a polar group (such as a carboxy group, a hydroxy group and an amide group) may be suitably used. The monomer having a polar group may be useful for introducing a cross-linking point into the acrylic polymer or increasing cohesive strength of the acrylic polymer. For the copolymerizable monomer, solely one species or a combination of two or more species can be used.

Non-limiting specific examples of the copolymerizable monomer include those indicated below.

Carboxyl group-containing monomers: for example, acrylic acid, methacrylic acid, carboxyethyl acrylate, carboxypentyl acrylate, itaconic acid, maleic acid, fumaric acid, crotonic acid and isocrotonic acid;

Acid anhydride group-containing monomers: for example, maleic anhydride and itaconic anhydride;

Hydroxy group-containing monomers: for example, hydroxyalkyl (meth)acrylates such as 2-hydroxyethyl (meth)acrylate, 2-hydroxypropyl (meth)acrylate, 2-hydroxybutyl (meth)acrylate, 3-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate and (4-hydroxymethylcyclohexyl)methyl (meth)acrylate;

Monomers having a sulphonate group or a phosphate group: for example, styrene sulphonic acid, allyl sulphonic acid, sodium vinylsulphonate, 2-(meth)acrylamide-2-methylpropane sulphonic acid, (meth)acrylamide propane sulphonic acid, sulphopropyl (meth)acrylate, (meth)acryloyloxy naphthalenesulphonic acid and 2-hydroxyethylacryloyl phosphate;

Epoxy group-containing monomers: for example, epoxy group-containing acrylates such as glycidyl (meth)acrylate and (meth)acrylate-2-ethyl glycidyl ether, allyl glycidyl ether and (meth)acrylate glycidyl ether;

Cyano group-containing monomers: for example, acrylonitrile and methacrylonitrile;

Isocyanato group-containing monomers: for example, 2-isocyanatoethyl (meth)acrylate;

Amido group-containing monomers: for example, (meth)acrylamide; N,N-dialkyl (meth)acrylamides such as N,N-dimethyl(meth)acrylamide, N,N-diethyl(meth)acrylamide, N,N-dipropyl(meth)acrylamide, N,N-diisopropyl(meth)acrylamide, N,N-di(n-butyl)(meth)acrylamide and N,N-di(t-butyl) (meth)acrylamide; N-alkyl (meth)acrylamides such as N-ethyl(meth)acrylamide, N-isopropyl(meth)acrylamide, N-butyl(meth)acrylamide and N-n-butyl(meth)acrylamide; N-vinylcarboxylic acid amides such as N-vinylacetamide; a monomer having a hydroxy group and an amide group, for example, an N-hydroxyalkyl(meth)acrylamide such as N-(2-hydroxyethyl)(meth)acrylamide, N-(2-hydroxypropyl)(meth)acrylamide, N-(1-hydroxypropyl)(meth)acrylamide, N-(3-hydroxypropyl)(meth)acrylamide, N-(2-hydroxybutyl)(meth)acrylamide, N-(3-hydroxybutyl)(meth)acrylamide, and N-(4-hydroxybutyl)(meth)acrylamide; a monomer having an alkoxy group

and an amide group, for example, an N-alkoxyalkyl(meth)acrylamide such as N-methoxymethyl(meth)acrylamide, N-methoxyethyl(meth)acrylamide, and N-butoxymethyl(meth)acrylamide; and N,N-dimethylaminopropyl(meth)acrylamide, N-(meth)acryloylmorpholine, etc.

Monomers having a nitrogen atom-containing ring: for example, N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-(meth)acryloyl-2-pyrrolidone, N-(meth)acryloylpiperidine, N-(meth)acryloylpyrrolidine, N-vinylmorpholine, N-vinyl-3-morpholinone, N-vinyl-2-caprolactam, N-vinyl-1,3-oxazin-2-one, N-vinyl-3,5-morpholinedione, N-vinylpyrazole, N-vinylisoxazole, N-vinylthiazole, N-vinylisothiazole and N-vinylpyridazine (such as lactams including N-vinyl-2-caprolactam);

Monomers having a succinimide skeleton: for example, N-(meth)acryloyloxy methylene succinimide, N-(meth)acryloyl-6-oxy hexamethylene succinimide and N-(meth)acryloyl-8-oxy hexamethylene succinimide;

Maleimides: for example, N-cyclohexylmaleimide, N-isopropylmaleimide, N-laurylmaleimide and N-phenylmaleimide;

Itaconimides: for example, N-methyl itaconimide, N-ethyl itaconimide, N-butyl itaconimide, N-octyl itaconimide, N-2-ethylhexyl itaconimide, N-cyclohexyl itaconimide and N-lauryl itaconimide;

Aminoalkyl (meth)acrylates: for example, aminoethyl (meth)acrylate, N,N-dimethylaminoethyl (meth)acrylate, N,N-diethylaminoethyl (meth)acrylate and t-butylaminoethyl (meth)acrylate;

Alkoxy group-containing monomers: for example, an alkoxyalkyl (meth)acrylate such as 2-methoxyethyl (meth)acrylate, 3-methoxypropyl (meth)acrylate, 2-ethoxyethyl (meth)acrylate, propoxyethyl (meth)acrylate, butoxyethyl (meth)acrylate and ethoxypropyl (meth)acrylate; and an alkoxy alkylene glycol (meth)acrylate such as methoxy ethylene glycol (meth)acrylate, methoxy propylene glycol (meth)acrylate, methoxy poly(ethylene glycol) (meth)acrylate and methoxy poly(propylene glycol) (meth)acrylate;

Vinyl esters: for example, vinyl acetate and vinyl propionate;

Vinyl ethers: for example, vinyl alkyl ethers such as methyl vinyl ether and ethyl vinyl ether;

Aromatic vinyl compounds: for example, styrene, $\alpha$-methylstyrene and vinyl toluene;

Olefins: for example, ethylene, butadiene, isoprene and isobutylene;

(Meth)acrylic esters having an alicyclic hydrocarbon group: for example, cyclopentyl (meth)acrylate, cyclohexyl (meth)acrylate, isobornyl (meth)acrylate and dicyclopentanyl (meth)acrylate;

(Meth)acrylic esters having an aromatic hydrocarbon group: for example, phenyl (meth)acrylate, phenoxyethyl (meth)acrylate and benzyl (meth)acrylate;

Heterocyclic ring-containing (meth)acrylates such as tetrahydrofurfuryl (meth)acrylate, halogen atom-containing monomers such as vinyl chloride and halogen atom-containing (meth)acrylates (for example, fluorine atom-containing (meth)acrylates), silicon atom-containing (meth)acrylates such as silicone (meth)acrylate, (meth)acrylic esters obtained from terpene compound derivative alcohols, and the like.

Copolymerizable monomers that can be preferably used in some embodiments include at least one monomer selected from the group consisting of an N-vinyl cyclic amide represented by the following general formula (M1) and a hydroxy group-containing monomer (possibly a monomer having a hydroxy group and other functional group, e.g. a monomer having a hydroxy group and an amide group).

[Chem 1]

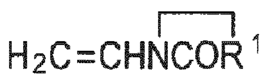

(M1)

Here, $R^1$ in the general formula (M1) is a divalent organic group.

Specific examples of the N-vinyl cyclic amide include N-vinyl-2-pyrrolidone, N-vinyl-2-piperidone, N-vinyl-3-morpholinone, N-vinyl-2-caprolactam, N-vinyl-1,3-oxazin-2-one, and N-vinyl-3,5-morpholinedione. N-vinyl-2-pyrrolidone and N-vinyl-2-caprolactam are particularly preferable.

Specific examples of hydroxy group-containing monomers that can be favorably used include 2-hydroxyethyl (meth)acrylate, 4-hydroxybutyl (meth)acrylate, 6-hydroxyhexyl (meth)acrylate and N-(2-hydroxyethyl)(meth)acrylamide. Among others, preferable examples include 2-hydroxyethyl acrylate (HEA), 4-hydroxybutyl acrylate (4HBA), and N-(2-hydroxyethyl)acrylamide (HEAA).

When using a copolymerizable monomer as described above, its amount used is not particularly limited, but it is usually suitably at least 0.01 % by weight of the total amount of monomers. From the standpoint of obtaining greater effect of the use of the copolymerizable monomer, the amount of copolymerizable monomer used can be 0.1 % by weight or more of the total amount of monomers, or even 1 % by weight or more. The amount of copolymerizable monomer used can be 50 % by weight or less of the total amount of monomers, or preferably 40 % by weight or less.

This can bring about greater contour-conformability.

The method for obtaining the acrylic polymer is not particularly limited. Various polymerization methods known as synthetic methods of acrylic polymers may be appropriately employed such as solution polymerization, emulsion polymerization, bulk polymerization, suspension polymerization and photopolymerization. In some embodiments, solution polymerization or photopolymerization may be preferably employed.

The initiator used for polymerization may be appropriately selected according to the polymerization method from heretofore known thermal polymerization initiators, photopolymerization initiators and the like. For the polymerization initiator, solely one species or a combination of two or more species can be used.

Examples of the thermal polymerization initiator include azo polymerization initiators, persulfates, peroxide polymerization initiators and redox polymerization initiators. The amount of thermal polymerization initiator used is not particularly limited, and may be, for example, in the range of 0.01 part by weight to 5 parts by weight and preferably 0.05 part by weight to 3 parts by weight relative to 100 parts by weight of monomers used for preparing the acrylic polymer.

The photopolymerization initiator is not particularly limited and examples thereof that may be used include benzoin ether photopolymerization initiators, acetophenone photopolymerization initiators, $\alpha$-ketol photopolymerization initiators, aromatic sulphonyl chloride photopolymerization initiators, photoactive oxime photopolymerization initiators, benzoin photopolymerization initiators, benzyl photopolymerization initiators, benzophenone photopolymerization initiators, ketal photopolymerization initiators, thioxanthone photopolymerization initiators, acylphosphine oxide photopolymerization initiators and the like. The amount of photopolymerization initiator used is not particularly limited, and may be, for example, in the range of 0.01 part by weight to 5 parts by weight and preferably 0.05 part by weight to 3 parts by weight relative to 100 parts by weight of monomers used for preparing the acrylic polymer.

In some embodiments, the resin composition for forming resin layers may include the acrylic polymer as a partial polymer (acrylic polymer syrup) obtainable by subjecting a mixture of monomers with a polymerization initiator to UV irradiation to polymerize part of the monomers. The resin composition containing such acrylic polymer syrup is applied to a certain substrate and irradiated with UV to complete the polymerization. In other words, the acrylic polymer syrup can be thought as a precursor of the acrylic polymer. The resin layer disclosed herein can be formed, using, for instance, a resin composition that includes the acrylic polymer as the base polymer in the acrylic polymer syrup form and includes, as necessary, a suitable amount of a polyfunctional monomer described later.

(Crosslinking agent)

In the resin layer, for purposes such as adjusting the cohesive strength, a crosslinking agent may be used as necessary. As the crosslinking agent, a crosslinking agent known in the field of resin (e.g. PVA) can be used, with examples including epoxy-based crosslinking agents, isocyanate-based crosslinking agent, silicone-based crosslinking agent, oxazoline-based crosslinking agent, aziridine-based crosslinking agent, silane-based crosslinking agent, alkyletherified melamine-based crosslinking agent and metal chelate-based crosslinking agents. In particular, isocyanate-based crosslinking agents, epoxy-based crosslinking agents and metal chelate-based crosslinking agents can be favorably used. For the crosslinking agent, solely one species or a combination of two or more species can be used.

When using a crosslinking agent, its amount used is not particularly limited. For instance, its amount can be greater than 0 part by weight relative to 100 parts b y weight of base polymer. The amount of crosslinking agent used to 100 parts by weight of base polymer can be, for instance, 0.01 part by weight or greater, or preferably 0.05 part by weight or greater. With increasing amount of crosslinking agent used, greater cohesive strength tends to be obtained. In some embodiments, the amount of crosslinking agent used to 100 parts by weight of base polymer can be 0.1 part by weight or greater, 0.5 part by weight or greater, or even 1 part by weight or greater. On the other hand, from the standpoint of avoiding degradation of contour-conformability caused by an excessive increase in cohesive strength, the amount of crosslinking agent used to 100 parts by weight of base polymer is usually suitably 15 parts by weight or less, 10 parts by weight or less, or even 5 parts by weight or less. The art disclosed herein can also be favorably implemented in an embodiment using no crosslinking agent.

To allow an aforementioned crosslinking reaction to proceed effectively, a crosslinking catalyst may be used. As the crosslinking catalyst, for instance, a tin-based catalyst (especially, dioctyltin dilaurate) can be preferably used. The amount of crosslinking catalyst used is not particularly limited. For instance, it can be about 0.0001 part to 1 part by weight to 100 parts by weight of base polymer.

In the resin layer, a polyfunctional monomer may be used as necessary. The polyfunctional monomer used in place of or in combination with a crosslinking agent as described above may be helpful for purposes such as adjusting the cohesive strength. For instance, in the resin layer formed from a photo-curable resin composition, a polyfunctional monomer can be preferably used.

Examples of the polyfunctional monomer include ethylene glycol di(meth)acrylate, propylene glycol di(meth)acrylate, polyethylene glycol di(meth)acrylate, polypropylene glycol di(meth)acrylate, neopentyl glycol di(meth)acrylate, pentaerythritol di(meth)acrylate, pentaerythritol tri(meth)acrylate, dipentaerythritol hexa(meth)acrylate, ethyleneglycol

di(meth)acrylate, 1,6-hexanediol di(meth)acrylate, 1,12-dodecanediol di(meth)acrylate, trimethylolpropane tri(meth)acrylate, tetramethylolmethane tri(meth)acrylate, allyl (meth)acrylate, vinyl (meth)acrylate, divinylbenzene, epoxy acrylate, polyester acrylate, urethane acrylate, butyldiol (meth)acrylate and hexyldiol di(meth)acrylate. Among them, trimethylolpropane tri(meth)acrylate, 1,6-hexanediol di(meth)acrylate and dipentaerythritol hexa(meth)acrylate can be favorably used. For the polyfunctional monomer, solely one species or a combination of two or more species can be used.

The amount of polyfunctional monomer used depends on its molecular weight, the number of functional groups therein, etc.; it is usually suitably in a range of about 0.01 part to 3 parts by weight to 100 parts by weight of base polymer. In some embodiments, the amount of polyfunctional monomer used to 100 parts by weight of base polymer can be, for instance, 0.02 part by weight or greater, or even 0.03 part by weight or greater. With increasing amount of polyfunctional monomer used, a higher cohesive strength tends to be obtained. On the other hand, from the standpoint of avoiding degradation of contour-conformability caused by an excessive increase in cohesive strength, the amount of polyfunctional monomer used to 100 parts by weight of base polymer can be 2.0 parts by weight or less, 1.0 part by weight or less, or even 0.5 part by weight or less.

(Tackifier resin)

The resin layer may include a tackifier resin as necessary. The tackifier resin is not particularly limited. Examples include a rosin-based tackifier resin, a terpene-based tackifier resin, a phenol-based tackifier resin, a hydrocarbon-based tackifier resin, a ketone-based tackifier resin, a polyamide-based tackifier resin, an epoxy-based tackifier resin, and an elastomer-based tackifier resin. For the tackifier resin, solely one species or a combination of two or more species can be used.

A preferable tackifier resin has a softening point (softening temperature) of about 80 °C or higher (preferably about 100 °C or higher, e.g. about 120 °C or higher). The maximum softening point is not particularly limited; it can be, for instance, about 200 °C or lower (typically 180 °C or lower). The softening point of a tackifier resin can be determined based on the softening point test method (ring and ball method) specified in JIS K 2207.

When using a tackifier resin, its amount included is not particularly limited and can be selected so that suitable adhesive properties are obtained in accordance with the purpose and application. The tackifier resin content (when two or more species of tackifier resins are included, their combined amount) to 100 parts by weight of base polymer can be, for instance, 5 parts by weight or greater, or even 10 parts by weight or greater. On the other hand, from the standpoint of enhancing the contour-conformability, in some embodiments, the tackifier resin content to 100 parts by weight of base polymer is suitably 100 parts by weight or less; it can be 50 parts by weight or less, or even 25 parts by weight or less. Alternatively, a tackifier resin may not be used.

(Filler)

The resin layer disclosed herein comprises a thermally conductive filler. The resin layer disclosed herein may include another filler that is not a thermally conductive filler as long as the effect of this invention is not significantly impaired. The following describes general fillers that can be used in this invention first and then thermally conductive fillers that can be used in this invention.

The filler is not particularly limited. For instance, a particulate or fibrous filler can be used. For the filler, solely one species or a combination of two or more species can be used.

The material forming the filler can be an inorganic material, with examples including metals such as copper, silver, gold, platinum, nickel, aluminum, chromium, iron, and stainless steel; metal oxides such as aluminum oxide, silicon oxides (typically silicon dioxide), titanium oxide, zirconium oxide, zinc oxide, tin oxide, antimonic acid-doped tin oxide, copper oxide, and nickel oxide; hydrated metal compounds such as aluminum hydroxide [$Al_2O_3 \cdot 3H_2O$ or $Al(OH)_3$], boehmite [$Al_2O_3 \cdot H_2O$ or AlOOH], magnesium hydroxide [$MgO \cdot H_2O$ or $Mg(OH)_2$], calcium hydroxide [$CaO \cdot H_2O$ or $Ca(OH)_2$], zinc hydroxide [$Zn(OH)_2$], silica [$H_4SiO_4$ or $H_2SiO_3$ or $H_2Si_2O_5$], iron hydroxide [$Fe_2O_3 \cdot H_2O$ or 2FeO(OH)], copper hydroxide [$Cu(OH)_2$], barium hydroxide [$BaO \cdot H_2O$ or $BaO \cdot 9H_2O$], hydrated zirconium oxide [$ZrO \cdot nH_2O$], hydrated tin oxide [$SnO \cdot H_2O$], basic magnesium carbonate [$3MgCO_3 \cdot Mg(OH)_2 - 3H_2O$], hydrotalcite [$6MgO \cdot Al_2O_3 \cdot H_2O$]dawsonite [$Na_2CO_3 \cdot Al_2O_3 . nH_2O$], borax [$Na_2O \cdot B_2O_5 \cdot 5H_2O$] and zinc borate [$2ZnO \cdot 3B_2O_5 \cdot 3.5H_2O$]; carbides such as silicon carbide, boron carbide, nitrogen carbide, and calcium carbide; nitrides such as aluminum nitride, silicon nitride, boron nitride, and gallium nitride; carbonates such as calcium carbonate; titanates including barium titanate and potassium titanate; carbon-based substances including carbon black, carbon tubes (typically carbon nanotubes), carbon fibers, and diamond; and glass; and polymers such as polystyrene, acrylic resin (e.g. polymethyl methacrylate), phenol resin, benzoguanamine resin, urea resin, silicone resin, polyester, polyurethane, polyethylene, polypropylene, polyamide (e.g. nylon, etc.), polyimide, and polyvinylidene chloride. Alternatively, particulate natural raw materials can also be used, such as volcanic shirasu (ash), clay and sand. As the fibrous filler, various synthetic fibers and natural fibers can be used.

A particulate filler is preferably used because it is less likely to impair the smoothness of the resin layer surface

even if it is included in the resin layer in a relatively large amount. The particle shape is not particularly limited; it may have a bulky shape, a needle-like shape, a flaky shape, or a layered shape. Examples of the bulky shape include a globular shape, a cuboid shape, a granular shape and deformed shapes of these. The particle structure is not particularly limited. For instance, it may have a compact structure, a porous structure, a hollow structure, etc.

When using a photocurable (e.g. UV curable) resin composition, from the standpoint of the photo curing ability (polymerization reactivity) of the resin composition, it is preferable to use a filler formed of an inorganic material.

In the art disclosed herein, as the thermally conductive filler, a filler formed from an inorganic material can be preferably used. Favorable examples of the thermally conductive filler include fillers having dense structures formed from hydrated metal compounds, metal oxides, metals, etc. A resin layer containing a thermally conductive filler tends to have greater thermal conductivity.

In some embodiments, a filler formed from a hydrated metal compound can be preferably used. The hydrated metal compounds generally start to decompose at temperatures between 150 °C and 500 °C; they are compounds represented by the general formula $MxOy \cdot nH_2O$ (M is a metal atom, x and y are integers of 1 or greater determined by the valence of the metal, and n is the number of waters of hydration) or double salts containing these compounds. A favorable example of the hydrated metal compound is aluminum hydroxide.

Hydrated metal compounds are commercially available. Examples of commercially available aluminum hydroxides include product names HIGILITE H-100-ME (mean primary particle diameter: 75 μm), HIGILITE H-10 (mean primary particle diameter: 55 μm), HIGILITE H-32 (mean primary particle diameter: 8 μm), HIGILITE H-31 (mean primary particle diameter: 20 μm) and HIGILITE H-42 (mean primary particle diameter: 1 μm) (all available from Showa Denko K.K.); and product name B103ST (mean primary particle diameter: 7 μm) (available from Nippon Light Metal Co., Ltd.). Examples of commercially available magnesium hydroxide include product name KISUMA 5A (mean primary particle diameter: 1 μm) (available from Kyowa Chemical Industry Co., Ltd.).

Examples of commercially available thermally conductive fillers other than hydrated metal compounds include boron nitride under product names HP-40 (available from Mizushima Ferroalloy Co., Ltd.) and PT620 (available from Momentive Performance Materials Inc.); aluminum oxide under product names AS-50 and AS-10 (available from Showa Denko K.K.); antimonic acid-doped tin under product names SN-100S, SN-100P and SN-100D (an aqueous dispersion) (all available from Ishihara Sangyo Kaisha, Ltd.); titanium oxide products under the TTO series (available from Ishihara Sangyo Kaisha, Ltd.); and zinc oxide under product names ZnO-310, ZnO-350 and ZnO-410 (available from Sumitomo Osaka Cement Co., Ltd.).

In the art disclosed herein, the difference between the refractive index nf of the thermally conductive filler in the resin layer and the refractive index np of the resin in the resin layer is 0.04 or less. According to an embodiment having a resin layer that combinedly comprises a resin and a thermally conductive filler between whom the difference in refractive index is small, a thermally conductive sheet with high optical transmission is likely to be obtained.

It does not matter which is greater between the resin's refractive index np and the thermally conductive filler's refractive index nf as long as their difference in refractive index satisfies the relation. In other words, in the art disclosed herein, the value of (np - nf) obtained by subtracting the thermally conductive filler's refractive index nf from the resin's refractive index np is within ±0.04. In some embodiments, np - nf is preferably -0.02 or greater and 0.04 or less, possibly 0 or greater and 0.03 or less, or even 0 or greater and 0.02 or less. In some other embodiments, np - nf can be -0.04 or greater and 0 or less, -0.04 or greater and -0.01 or less, or even -0.04 or greater and -0.02 or less. When the value obtained by subtracting the thermally conductive filler's refractive index nf from the resin's refractive index np is within these ranges, a thermally conductive sheet with high optical transmission is likely to be obtained.

The thermally conductive filler's refractive index nf is not particularly limited as long as it satisfies the relation with the resin's refractive index np. In some embodiments, the thermally conductive filler's refractive index nf is preferably 1.70 or lower, more preferably 1.65 or lower, or yet more preferably 1.60 or lower. The minimum refractive index nf of the thermally conductive filler is not particularly limited. It is usually 1.45 or higher, preferably 1.50 or higher, or yet more preferably 1.55 or higher.

The thermally conductive filler content in the resin layer is not particularly limited. It can be selected in accordance with the thermal conductivity desired for the thermally conductive sheet, etc. The thermally conductive filler content relative to 100 parts by weight of the resin in the resin layer can be 5 parts by weight or greater, 10 parts by weight or greater, or even 33 parts by weight or greater. To 100 parts by weight of the resin, the thermally conductive filler content is preferably 50 parts by weight or greater, more preferably 66 parts by weight or greater, or yet more preferably 100 parts by weight or greater. With increasing thermally conductive filler content, the resin layer tends to show greater thermal conduction. In some embodiments, the thermally conductive filler content can be 120 parts by weight or greater, 150 parts by weight or greater, or even 185 parts by weight or greater, relative to 100 parts by weight of the resin in the resin layer. From the standpoint of minimize reduction of optical transmission of the resin layer or from the standpoint of preventing the resin layer from having a less smooth surface so as to readily obtain a good state of tight contact with a component (e.g. an adherend), the thermally conductive filler content relative to 100 parts by weight of the resin in the resin layer is suitably 900 parts by weight or less, preferably 400 parts by weight or less, more preferably 300 parts by

weight, possibly 250 parts by weight or less, or even 200 parts by weight or less.

The mean particle diameter of the thermally conductive filler is not particularly limited. The mean particle diameter is usually suitably 100 μm or less, preferably 50 μm or less, or possibly even 20 μm or less. With decreasing mean particle diameter, the surface of the resin layer tends to be smoother, leading to tighter adhesion to a component (e.g. adherend). In some embodiments, the thermally conductive filler may have a mean particle diameter of 10 μm or less, 5 μm or less, or even 3 μm or less. The filler's mean particle diameter can be, for instance, 0.1 μm or greater, 0.2 μm or greater, or even 0.5 μm or greater. It can be advantageous to have not too small a mean particle diameter from the standpoint of the ease of handling and dispersing the thermally conductive filler.

In some embodiments, relative to the thickness Ta of the resin layer, the thermally conductive filler's mean particle diameter is preferably less than 0.5Ta. Here, in this description, unless otherwise informed, the thermally conductive filler's mean particle diameter refers to the 50th-percentile particle diameter (median diameter) corresponding to 50 % cumulative weight in a given size distribution obtained by a screening analysis. When the thermally conductive filler's mean particle diameter is less than 50 % of the resin layer's thickness Ta, it can be said that 50 % by weight or more of the thermally conductive filler in the resin layer have particle diameters smaller than the resin layer's thickness Ta. When 50 % by weight or more of the thermally conductive filler in the resin layer have particle diameters smaller than the resin layer's thickness Ta, there is a higher tendency for the resin layer surface (adhesive face if the resin layer is PSA) to maintain good surface conditions (e.g. smoothness). This is preferable from the standpoint of obtaining tighter adhesion to the object in contact (e.g. adherend) to increase the thermal conductivity.

The thermally conductive sheet disclosed herein can be preferably made in an embodiment where, in the particle distribution obtained by the scanning analysis, 60 % by weight or more of the thermally conductive filler in the resin layer have particle diameters smaller than the resin layer's thickness Ta (more preferably than 0.7Ta, or yet more preferably than 0.5Ta). Of the thermally conductive filler, the ratio of particles having particle diameters smaller than the resin layer's thickness Ta (more preferably than 0.7Ta, or yet more preferably than 0.5Ta) can be, for instance, 70 % by weight or more, 80 % by weight or more, or even 90 % by weight or more. It is more preferable that substantially all of the thermally conductive filler in the resin layer have particle diameters smaller than the resin layer's thickness Ta (more preferably than 0.7Ta, or yet more preferably than 0.5Ta). Here, "substantially all" typically means 99 % by weight or more and 100 % by weight or less, for instance, 99.5 % by weight or more and 100 % by weight or less.

(Dispersing agent)

The resin composition for forming resin layers may comprise, as necessary, a dispersing agent to well disperse the filler in the resin composition. The resin composition with a well dispersed thermally conductive filler can form a resin layer with more uniform thermal conductivity.

As the dispersing agent, a known surfactant can be used. The surfactant encompasses nonionic, anionic, cationic and amphoteric surfactants. For the dispersing agent, solely one species or a combination of two or more species can be used.

One example of preferable dispersing agent is a phosphoric acid ester. For instance, a monoester, diester, triester of phosphoric acid, a mixture of these and the like can be used. Specific examples of the phosphoric acid ester include phosphoric acid monoesters of polyoxyethylene alkyl ether, polyoxyethylene alkyl aryl ether or polyoxyethylene aryl ether, the corresponding phosphoric acid diesters, the corresponding phosphoric acid triesters, and derivatives of these. Favorable examples include phosphoric acid monoesters of polyoxyethylene alkyl ether or polyoxyethylene alkyl aryl ether, and phosphoric acid diesters of polyoxyethylene alkyl ether or polyoxyethylene alkyl aryl ether. The number of carbon atoms of the alkyl group in such a phosphoric acid ester is, for instance, 6 to 20, preferably 8 to 20, or more preferably 10 to 18, typically 12 to 16.

As the phosphoric acid ester, a commercially available product can be used. Examples include trade names PLYSURF A212E, PLYSURF A210G, PLYSURF A212C and PLYSURF A215C available from DKS Co., Ltd., and trade names PHOSPHANOL RE610, PHOSPHANOL RS710 and PHOSPHANOL RS610 available from TOHO Chemical Industry Co., Ltd.

The amount of dispersing agent used to 100 parts by weight of filler can be, for instance, 0.01 part to 25 parts by weight; it is usually suitably 0.1 part to 25 parts by weight. From the standpoint of preventing troubled application of the resin composition and roughening of the surface caused by poor dispersion of the filler, the amount of dispersing agent used to 100 parts by weight of filler is preferably 0.5 part by weight or greater, more preferably 1 part by weight or greater, yet more preferably 2 parts by weight or greater, or even 5 parts by weight or greater. From the standpoint of avoiding deterioration of properties such as adhesiveness caused by an excessive use of dispersing agent, the amount of dispersing agent used to 100 parts by weight of filler is preferably 20 parts by weight or less, more preferably 15 parts by weight or less, possibly 12 parts by weight or less, or even 10 parts by weight or less.

Relative to 100 parts by weight of the thermally conductive filler, the dispersing agent can be used in an amount of, for instance, 0.01 part to 25 parts by weight, or usually suitably 0.1 part to 25 parts by weight. From the standpoint

of preventing hindrance to the application of the resin composition and deterioration of surface smoothness caused by poor dispersion of the thermally conductive filler, the amount of the dispersing agent used to 100 parts by weight of the thermally conductive filler is preferably 0.15 part by weight or greater, more preferably 0.3 part by weight or greater, yet more preferably 0.5 part by weight or greater, or possibly 1 part by weight or greater. From the standpoint of avoiding degradation of properties such as the resin's adhesive properties caused by excessive use of the dispersing agent, the amount of the dispersing agent used to 100 parts by weight of the thermally conductive filler is preferably 20 parts by weight or less, more preferably 15 parts by weight or less, possibly 12 parts by weight or less, or even 10 parts by weight or less.

Besides the above, as far as the effect of this invention is not significantly impaired, the resin layer in the art disclosed herein may include, as necessary, known additives that can be used in resin (e.g. PSA), such as leveling agent, plasticizer, softener, colorant (dye, pigment, etc.), antistatic agent, anti-aging agent, UV absorber, antioxidant, photo stabilizer, and preservative.

(Formation of resin layer)

The resin layer in the thermally conductive sheet disclosed herein may be a cured layer of the resin composition. In other words, it can be formed by providing (e.g. applying) the resin composition to a suitable surface and then subjecting it to a suitable curing process. When two or more different curing processes (drying, crosslinking, polymerization, etc.) are carried out, these can be done at the same time or in stages. When a partial polymer (e.g. acrylic polymer syrup) of monomers are used for the resin composition, a final copolymerization reaction is typically carried out as the curing process. That is, the partial polymer is subjected to a further copolymerization reaction to form a fully polymerized product. For instance, with respect to a photocurable resin composition, photoirradiation is carried out. As necessary, curing processes such as crosslinking and drying can be performed. For instance, with respect to a photocurable resin composition that needs to be dried, photocuring should be carried out after drying. With respect to a resin composition using a fully polymerized product, processes such as drying (drying with heat) and crosslinking are typically carried out as necessary as the curing process.

The resin composition can be applied with, for example, a conventional coater such as a gravure roll coater, a reverse roll coater, a kiss-roll coater, a dip roll coater, a bar coater, a knife coater and a spray coater.

In the thermally conductive sheet disclosed herein, the thickness of the resin layer is not particularly limited. From the standpoint of increasing the thermal conduction and optical transmission, the thickness of the resin layer is usually suitably 600 μm or less, preferably 300 μm or less, more preferably 100 μm or less, possibly less than 100 μm, 80 μm or less, 70 μm or less, 60 μm or less, or even 55 μm or less. From the standpoint of increasing the contour conformability (or contour-absorbing ability) of the thermally conductive sheet, in some embodiments, the thickness of the resin layer can be, for instance, 5 μm or greater, 10 μm or greater, 20 μm or greater, 30 μm or greater, or even 40 μm or greater.

In some embodiments, the resin layer can be formed from a solvent-free resin composition. Here, the term "solvent-free" indicates that the solvent content of the resin composition is 5 % by weight or less, typically 1 % by weight or less. The solvent refers to a component that is not included in the final resin layer. Thus, for instance, unreacted monomers and the like possibly present in acrylic polymer syrup are excluded from the concept of solvent. As the solvent-free resin composition, for instance, a photo curable or hot-melt resin composition can be used. In particular, a resin layer formed from a photo curable (e.g. UV curable) resin composition is preferable. Formation of the resin layer using a photo curable resin composition is often carried out in an embodiment where the resin composition is placed between two sheets and subjected to photoirradiation for curing in a state where the air is blocked.

<Applications>

The thermally conductive sheet disclosed herein can be used for heat dissipation of a component (e.g. an adherend) in contact with the thermally conductive sheet or for heat conduction through the thermally conductive sheet. The thermally conductive sheet disclosed herein is highly transparent. Thus, with respect to a device constructed with the thermally conductive sheet, the device is likely to be constructed with increased accuracy. Accordingly, the thermally conductive sheet disclosed herein is suited for heat dissipation of components in high-tech devices, small high-tech devices and the like that require high levels of accuracy; or for heat conduction through the thermally conductive sheet.

When the thermally conductive sheet disclosed herein is configured as a thermally conductive PSA sheet, the thermally conductive PSA sheet is highly transparent and pressure-sensitive adhesive; and therefore, in addition to heat dissipation of an adherend or heat conduction through the thermally conductive sheet, it is also suited for fixing, bonding and supporting components in high-tech devices and the like.

EXAMPLES

Several working examples related to the present invention are described below, but these specific examples are not to limit the present invention. In the description below, "parts" and "%" are by weight unless otherwise specified.

<Example 1>

(Preparation of resin composition)

Were mixed 58 parts of a fluorene acrylate (product name OGSOL EA-0300 available from Osaka Gas Chemical Co., Ltd.) and 42 parts of phenylphenol acrylate (ethoxylated o-phenylphenol acrylate, product name A-LEN-10 available from Shin-Nakamura Chemical Co., Ltd.) as monomers, 200 parts of aluminum hydroxide (product name Aluminum Hydroxide B103 available from Nippon Keikinzoku KK, mean particle diameter 7 μm) as a thermally conductive filler to the combined 100 parts of the monomers, 1.25 parts of product name PLYSURF A212E (available from DKS Co., Ltd.) as a filler-dispersing agent, 0.05 part of 1-hydroxycyclohexyl phenyl ketone (product name IRGACURE 184 available from BASF Corporation) and 0.05 part of 2,2-dimethoxy-1,2-diphenylethane-1-one (trade name IRGACURE 651 available from BASF Corporation) as photopolymerization initiators. The resulting mixture was stirred at 1000 rpm for five minutes to prepare a resin composition C1.

(Formation of resin layer)

Two different release liners R1 and R2 were obtained, each having a release surface formed with a silicone-based release agent on one side of a polyester film. As the release liner R1, was used product name DIAFOIL MRF (38 μm thick) available from Mitsubishi Plastics, Inc. As the release liner R2, was used product name DIAFOIL MRE (38 μm thick) available from Mitsubishi Plastics, Inc.

The resin composition C1 prepared above was applied to the release surface of release liner R1 to form a 50 μm thick coating layer. Subsequently, to the surface of the coating layer was covered with release liner R2 with the release surface on the coating layer side to block oxygen from the coating layer. Using a chemical light lamp available from Toshiba Corporation, the laminate sheet (having a layered structure of release liner R1/coating layer/release liner R2) was irradiated by UV at an intensity of 3 $mW/cm^2$ for 360 seconds to cure the coating layer and form a resin layer. A thermally conductive sheet formed of the resin layer was thus fabricated. The intensity value was determined by an industrial UV checker (available from Topcon Corporation, product name UVR-T1 with light detector model number UD-T36) with peak sensitivity at 350 nm in wavelength.

<Example 2>

The amount of aluminum hydroxide added was changed to 100 parts to the combined 100 parts of the monomers. Otherwise in the same manner as Example 1, was prepared a thermally conductive sheet according to this Example.

<Example 3>

The amounts of the fluorene acrylate and phenylphenol acrylate added were changed to 17 parts and 83 parts, respectively. Otherwise in the same manner as Example 2, was prepared a thermally conductive sheet according to this Example.

<Example 4>

The amounts of the fluorene acrylate and phenylphenol acrylate added were changed to 83 parts and 17 parts, respectively. Otherwise in the same manner as Example 2, was prepared a thermally conductive sheet according to this Example.

<Example 5>

Were mixed 50 parts of 2-ethylhexyl acrylate (2EHA), 50 parts of benzyl acrylate (product name VISCOAT #160 available from Osaka Organic Chemical Industry, Ltd.), 5 parts of N-vinyl-2-pyrrolidone (NVP), 2 parts of acrylic acid (AA) and 1 part of 4-hydroxbutyl acrylate (4HBA) as monomers; and 0.05 part of 1-hydroxycyclohexyl phenyl ketone (trade name IRGACURE 184 available from BASF Corporation) and 0.05 part of 2,2-dimethoxy-1,2-diphenylethane-1-one (trade name IRGACURE 651 available from BASF Corporation) as photopolymerization initiators. The resulting

mixture was subjected to UV irradiation under a nitrogen atmosphere. The polymerization was carried out to a viscosity of about 10 Pa ·s (BH viscometer, No. 5 rotor, 10 rpm, measurement temperature 30 °C) to prepare a partial polymer (5 % conversion). To 70 parts of the resulting partial polymer, was added 30 parts of benzyl acrylate (product name VISCOAT #160 available from Osaka Organic Chemical Industry, Ltd.) as a diluent monomer to prepare an acrylic polymer A5 as an acrylic polymer syrup.

To 100 parts of the resulting acrylic polymer A5 (acrylic polymer syrup), were added 0.08 part of dipentaerythritol hexaacrylate (product name KAYARAD DPHA-40H available from Nippon Kayaku Co., Ltd.) as a polyfunctional monomer, 1.25 parts of product name PLYSURF A212E (available from DKS Co., Ltd.) as a filler-dispersing agent and 200 parts of aluminum hydroxide (product name Aluminum Hydroxide B103 available from Nippon Keikinzoku KK, mean particle diameter 7 μm) as a thermally conductive filler. The resulting mixture was uniformly mixed to prepare a resin composition C5.

Using the resulting resin composition C5 in place of the resin composition C1, but otherwise in the same manner as Example 1, was prepared a thermally conductive sheet according to this Example. The resin layer in the thermally conductive sheet according to this Example was pressure-sensitive adhesive. In other words, the thermally conductive sheet according to this Example was in the form of an adhesively double-faced PSA sheet.

<Example 6>

The aluminum hydroxide and filler-dispersing agent were omitted. Otherwise in the same manner as Example 1, was prepared a thermally conductive sheet according to this Example.

<Example 7>

As the diluent monomer, was used 30 parts of 2-ethylhexyl acrylate (2EHA) in place of benzyl acrylate. Otherwise in the same manner as Example 5, was prepared a thermally conductive sheet according to this Example.

<Example 8>

Were mixed 80 parts of 2-ethylhexyl acrylate (2EHA), 12 parts of 2-methoxyethyl acrylate (MEA), 7 parts of N-vinyl-2-pyrrolidone (NVP) and 1 part of N-(2-hydroxyethyl)acrylamide (HEAA) as monomers; and 0.05 part of 1-hydroxycyclohexyl phenyl ketone (trade name IRGACURE 184 available from BASF Corporation) and 0.05 part of 2,2-dimethoxy-1,2-diphenylethane-1-one (trade name IRGACURE 651 available from BASF Corporation) as photopolymerization initiators. The resulting mixture was subjected to UV irradiation under a nitrogen atmosphere. The polymerization was carried out to a viscosity of about 20 Pa ·s (BH viscometer, No. 5 rotor, 10 rpm, measurement temperature 30 °C) to prepare an acrylic polymer A8 as a partial polymer (acrylic polymer syrup) in which the monomers were partially polymerized.

To 100 parts of the resulting acrylic polymer A8 (acrylic polymer syrup), were added 0.05 part of dipentaerythritol hexaacrylate (product name KAYARAD DPHA-40H available from Nippon Kayaku Co., Ltd.) as a polyfunctional monomer, 0.9 part of product name PLYSURF A212E (available from DKS Co., Ltd.) as a filler-dispersing agent and 100 parts of aluminum hydroxide (product name Aluminum Hydroxide B103 available from Nippon Keikinzoku KK, mean particle diameter 7 μm) as a thermally conductive filler. The resulting mixture was uniformly mixed to prepare a resin composition C8.

Using the resulting resin composition C8 in place of the resin composition C1, but otherwise in the same manner as Example 1, was prepared a thermally conductive sheet according to this Example.

<Example 9>

The amount of aluminum hydroxide added was changed to 250 parts to 100 parts of the acrylic polymer. Otherwise in the same manner as Example 8, was prepared a thermally conductive sheet according to this Example.

<Refractive index>

Resin compositions obtained by excluding the aluminum hydroxide as the thermally conductive filler from the resin compositions used to prepare the thermally conductive sheets according to the respective Examples were allowed to cure in the same manner as the method for preparing the thermally conductive sheets described above. Refractive indices of the resulting resins were determined at a wavelength of 589 nm at 23 °C (the same applies to the refractive index determination of thermally conductive filler below), using a multi-wavelength Abbe refractometer (model DR-M2 available from ATAGO Co., Ltd.). The results are shown under "Refractive index nᴅ" in Table 1. With respect to the

aluminum hydroxide used as the thermally conductive filler to prepare the thermally conductive sheets according to the respective Examples, the refractive index was measured. The resulting value is shown under "Refractive index nf" in Table 1. With respect to the thermally conductive sheet according to each Example, from the resin's refractive index np, the filler's refractive index nf was subtracted to determine the difference. The results are shown under "Difference in refractive index np - nf" in Table 1.

<Determination of transmittance>

Using a high-speed integrating sphere spectrophotometric transmittance meter (model DOT-3) available from Murakami Color Research Laboratory, at a temperature of 23 °C, the thermally conductive sheet according to each Example was irradiated over one face at a right angle by light with 400 nm wavelength and the intensity of light transmitted to the other face was measured to determine the transmittance of the thermally conductive sheet. The results are shown under "Transmittance" in Table 1.

<Determination of thermal conductivity>

With respect to the thermally conductive sheet according to each Example, thermal conductivity in the thickness direction was evaluated, using the thermal analysis instrument shown in Fig. 5(a), (b). Here, Fig. 5(a) shows a diagram outlining the front view of the thermal analysis instrument and Fig. 5(b) shows a diagram outlining the lateral view of the thermal analysis instrument. It is noted that the release liners R1 and R2 were removed for the measurement.

In particular, a thermally conductive sheet S (20 mm × 20 mm square) was brought in tight contact with a pair of 20 mm side cube blocks (or rods) L made of aluminum (A5052, thermal conductivity: 140 W/m·K), thereby bonding the pair of blocks L to each other with the thermally conductive sheet S. Then, the pair of rods L were vertically aligned between a heater block H and a heat radiator C (a cooling base plate with internally circulating cooling water). Specifically, the heater block H was arranged on the top block L and the heat radiator C was placed under the bottom block L.

Here, the pair of blocks L in tight contact with the thermally conductive sheet S were positioned between a pair of pressure-adjusting screws J put through the heater block H and heat radiator C. A load cell R was placed between each pressure-adjusting screw J and the heater block H so as to measure the pressure when tightening the pressure-adjusting screw J. The pressure measured was used as the pressure applied on the thermally conductive sheet S. In particular, in this test, the pressure-adjusting screws J were tightened to a pressure of 25 $N/cm^2$ (250 kPa) applied on the thermally conductive sheet S.

Three probes P (1 mm diameter) of a contact displacement meter were put through the bottom block L to the thermally conductive sheet S from the heat radiator C side. Here, the top end of each probe P was placed in contact with the bottom face of the top block L to enable measurement of the distance between the top and bottom blocks L (the thickness of the thermally conductive sheet S).

Temperature sensors D were installed in the heater block H and the top and bottom blocks L. In particular, a temperature sensor D was attached to one location in the heater block H. In addition, to five locations in each block L, temperature sensors D were attached at 5 mm intervals in the vertical direction.

For the measurement, the pressure-adjusting screws J were tightened to apply pressure to the thermally conductive sheet S; while the temperature of the heater block H was set at 80 °C, cooling water at 20° C was allowed to circulate through the heat radiator C.

After the temperatures of the heater block H and the top and bottom blocks L stabilized, the temperatures of the top and bottom blocks L were measured with the respective temperature sensors D. From the thermal conductivities (W/m·K) of the top and bottom blocks L and the temperature gradient between them, the heat flux passing through the thermally conductive sheet S was determined, and the temperatures at the interfaces between the thermally conductive sheet S and the top and bottom blocks L were determined. Using these values and the thermal conductivity formulas (Fourier's law) shown below, the thermal conductivity (W/m·K) at the particular pressure was determined. The resulting values are shown under "Thermal conductivity" in Table 1.

$$Q = -\lambda \mathrm{grad}T$$

wherein

Q: heat flow per unit area
gradT: temperature gradient
λ: thermal conductivity

[Table 1]

Table 1

| Example | Resin | Aluminum hydroxide | | Difference in refractive index np - nf | Transmittance (%) | Thermal conductivity (W/m·K) |
|---|---|---|---|---|---|---|
| | Refractive index np | Amount added to 100 parts of resin ( parts) | Refractive index nf | | | |
| 1 | 1.587 | 200 | 1.57 | 0.017 | 81.1 | 0.5 |
| 2 | 1.587 | 100 | 1.57 | 0.017 | 87.5 | 0.3 |
| 3 | 1.603 | 100 | 1.57 | 0.033 | 86.4 | 0.3 |
| 4 | 1.571 | 100 | 1.57 | 0.001 | 89.1 | 0.3 |
| 5 | 1.531 | 200 | 1.57 | -0.039 | 84.1 | 0.3 |
| 6 | 1.587 | 0 | - | - | 90.2 | 0.1 |
| 7 | 1.502 | 200 | 1.57 | -0.068 | 76.8 | 0.3 |
| 8 | 1.486 | 100 | 1.57 | -0.084 | 71.2 | 0.3 |
| 9 | 1.486 | 250 | 1.57 | -0.084 | 66.8 | 0.6 |

With respect to the thermally conductive sheets of Examples 1 to 5 comprising aluminum hydroxide as the thermally conductive filler and having np - nf values within ±0.04, thermal conduction was clearly higher than that of the thermally conductive sheet of Example 6. In addition, they exhibited higher transmittance as compared to the thermally conductive sheets of Examples 7 to 9.

Although specific embodiments of the present invention have been described in detail above, these are merely for illustrations and do not limit the scope of claims. The art according to the claims includes various modifications and changes made to the specific embodiments illustrated above.

[Reference Signs List]

10: thermally conductive sheet

12: resin layer

12A: first face

12B: second face

20: thermally conductive PSA sheet (double-faced PSA sheet)

22: resin layer (PSA layer)

22A: first adhesive face

22B: second adhesive face

24: release liner

26: release liner

30: thermally conductive PSA sheet (double-faced PSA sheet)

32: support substrate

32A: first face

32B: second face

34: first resin layer

34A: first resin layer's surface (first adhesive face)

36: second resin layer

36A: second resin layer's surface (second adhesive face)

38: release liner

39: release liner

40: thermally conductive PSA sheet (double-faced PSA sheet)

42: resin layer

42A: first face

42B: second face

44: first PSA layer

44A: first PSA layer's surface (first adhesive face)

46: second PSA layer

46A: second PSA layer's surface (second adhesive face)

48: release liner

49: release liner

200: release-lined thermally conductive PSA sheet

300: release-lined thermally conductive PSA sheet

400: release-lined thermally conductive PSA sheet

**Claims**

1. A thermally conductive sheet that has a resin layer comprising a resin and a thermally conductive filler, wherein the resin has a refractive index np and the thermally conductive filler has a refractive index nf, satisfying the next relational expression $-0.04 \leq (np - nf) \leq 0.04$.

2. The thermally conductive sheet according to Claim 1, wherein the thermally conductive filler is comprised in an amount of 50 parts by weight or more and 250 parts by weight or less to 100 parts by weight of the resin.

3. The thermally conductive sheet according to Claim 1 or 2, wherein the resin comprises an acrylic polymer as its base polymer.

4. The thermally conductive sheet according to Claim 3, wherein

the acrylic polymer is a polymer of starting monomers that comprise a monomer A, and
the monomer A is a monomer whose homopolymer is a highly refractive polymer having a refractive index of 1.50 or higher.

**5.** The thermally conductive sheet according to Claim 4, wherein the monomer A is at least one species selected from the group consisting of a fluorene-based (meth)acrylate, phenylphenol (meth)acrylate and benzyl (meth)acrylate.

**6.** The thermally conductive sheet according to Claim 4 or 5, wherein the monomer A accounts for 50 % by weight or more of the total amount of the starting monomers.

**7.** The thermally conductive sheet according to any one of Claims 1 to 6, wherein the thermally conductive filler comprises a hydrated metal compound.

**8.** The thermally conductive sheet according to any one of Claims 1 to 7, wherein the resin's refractive index np is 1.49 or higher and 1.65 or lower.

**9.** The thermally conductive sheet according to any one of Claims 1 to 8, wherein the resin layer is a pressure-sensitive adhesive layer.

[Fig. 1]

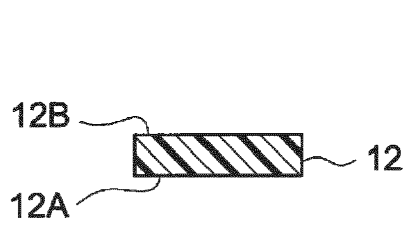


[Fig. 2]

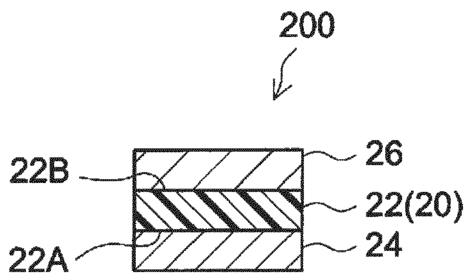


[Fig. 3]

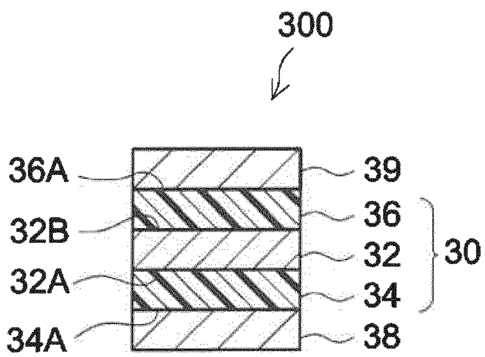

[Fig. 4]

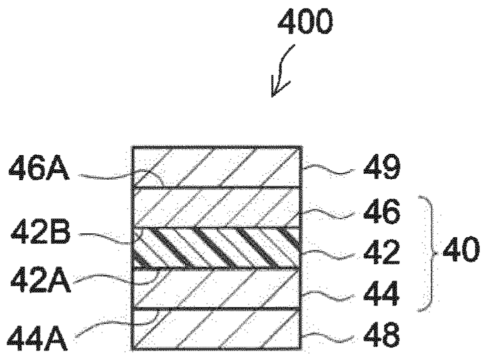
400
46A
42B
42A
44A
49
46
42
44
48
40

[Fig. 5]

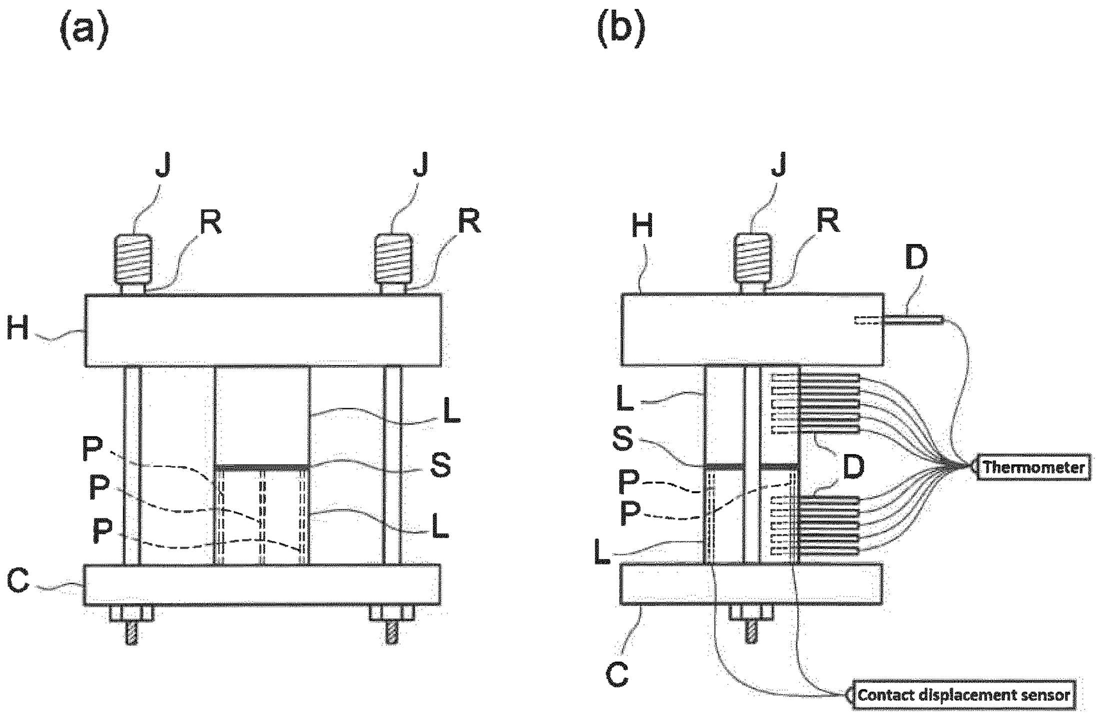
(a)
(b)
J
R
H
L
S
P
C
D
Thermometer
Contact displacement sensor

Europäisches Patentamt
European Patent Office
Office européen des brevets

# EUROPEAN SEARCH REPORT

Application Number
EP 19 18 8301

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 2 674 464 A1 (NITTO DENKO CORP [JP]) 18 December 2013 (2013-12-18)<br>* paragraph [0022]; claims 1-9 *<br>----- | 1-9 | INV.<br>C09J7/00<br>H01L33/64 |
| Y | US 2015/062505 A1 (HATANAKA NOBUYUKI [JP] ET AL) 5 March 2015 (2015-03-05)<br>* paragraph [0233] *<br>* paragraph [0230] - paragraph [0232] *<br>----- | 1-9 | |
| A | EP 2 207 050 A2 (SONY CORP [JP]) 14 July 2010 (2010-07-14)<br>* paragraph [0108] *<br>* paragraph [0128] *<br>* paragraph [0160] *<br>----- | 1-9 | |
| A | US 2017/323780 A1 (KOGA SHIN [JP] ET AL) 9 November 2017 (2017-11-09)<br>* paragraph [0077] - paragraph [0078] *<br>* paragraph [0122] - paragraph [0127] *<br>----- | 1-9 | |
| A | EP 2 692 759 A1 (HITACHI CHEMICAL CO LTD [JP]) 5 February 2014 (2014-02-05)<br>* claims 1-15 *<br>----- | 1-9 | TECHNICAL FIELDS SEARCHED (IPC)<br>C09J<br>H01L |

The present search report has been drawn up for all claims

1

| Place of search | Date of completion of the search | Examiner |
|---|---|---|
| The Hague | 26 November 2019 | But, Gabriela-Ileana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 19 18 8301

This annex lists the patent family members relating to the patent documents cited in the above-mentioned European search report. The members are as contained in the European Patent Office EDP file on
The European Patent Office is in no way liable for these particulars which are merely given for the purpose of information.

26-11-2019

| Patent document cited in search report | Publication date | Patent family member(s) | Publication date |
|---|---|---|---|
| EP 2674464 A1 | 18-12-2013 | CN 103347971 A | 09-10-2013 |
| | | EP 2674464 A1 | 18-12-2013 |
| | | JP 5812754 B2 | 17-11-2015 |
| | | JP 2012180495 A | 20-09-2012 |
| | | KR 20140048842 A | 24-04-2014 |
| | | TW 201233761 A | 16-08-2012 |
| | | US 2014004342 A1 | 02-01-2014 |
| | | WO 2012108289 A1 | 16-08-2012 |
| US 2015062505 A1 | 05-03-2015 | CN 104345373 A | 11-02-2015 |
| | | JP 6551154 B2 | 31-07-2019 |
| | | JP 2015163934 A | 10-09-2015 |
| | | JP 2016027431 A | 18-02-2016 |
| | | JP 2019091088 A | 13-06-2019 |
| | | KR 20150018427 A | 23-02-2015 |
| | | TW 201527091 A | 16-07-2015 |
| | | US 2015062505 A1 | 05-03-2015 |
| EP 2207050 A2 | 14-07-2010 | CN 101819288 A | 01-09-2010 |
| | | EP 2207050 A2 | 14-07-2010 |
| | | JP 5724171 B2 | 27-05-2015 |
| | | JP 2010181862 A | 19-08-2010 |
| | | KR 20100082733 A | 19-07-2010 |
| | | RU 2009148575 A | 27-06-2011 |
| | | TW 201037367 A | 16-10-2010 |
| | | US 2010177398 A1 | 15-07-2010 |
| US 2017323780 A1 | 09-11-2017 | CN 107078108 A | 18-08-2017 |
| | | JP 6508213 B2 | 08-05-2019 |
| | | JP WO2016072429 A1 | 05-10-2017 |
| | | KR 20170082562 A | 14-07-2017 |
| | | TW 201622989 A | 01-07-2016 |
| | | US 2017323780 A1 | 09-11-2017 |
| | | WO 2016072429 A1 | 12-05-2016 |
| EP 2692759 A1 | 05-02-2014 | CN 103429634 A | 04-12-2013 |
| | | EP 2692759 A1 | 05-02-2014 |
| | | JP 5431595 B2 | 05-03-2014 |
| | | JP 6048039 B2 | 21-12-2016 |
| | | JP 2013018991 A | 31-01-2013 |
| | | JP WO2012133587 A1 | 28-07-2014 |
| | | KR 20140007894 A | 20-01-2014 |
| | | TW 201249921 A | 16-12-2012 |
| | | US 2014015000 A1 | 16-01-2014 |
| | | WO 2012133587 A1 | 04-10-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2018141176 A
- JP 2013176980 A